(19) Europäisches Patentamt
European Patent Office
Office européen des brevets

(11) Veröffentlichungsnummer: **0 006 125 B1**

(12) # EUROPÄISCHE PATENTSCHRIFT

(45) Veröffentlichungstag der Patentschrift: **11.05.83**

(51) Int. Cl.³: **G 03 F 7/10**, G 03 C 1/68

(21) Anmeldenummer: **79101411.1**

(22) Anmeldetag: **09.05.79**

(54) **Photopolymerisierbares Gemisch und lichtempfindliches Schichtübertragungsmaterial.**

(30) Priorität: **20.05.78 DE 2822191**

(43) Veröffentlichungstag der Anmeldung:
**09.01.80 Patentblatt 80/1**

(45) Bekanntmachung des Hinweises auf die Patenterteilung:
**11.05.83 Patentblatt 83/19**

(84) Benannte Vertragsstaaten:
**BE CH DE FR GB IT NL SE**

(56) Entgegenhaltungen:
DE - A - 1 915 084
DE - A - 2 064 079
DE - B - 1 283 796
FR - A - 2 009 250
FR - A - 2 308 127
US - A - 2 198 582
US - A - 2 198 583
US - A - 3 395 060
US - A - 3 850 770

(73) Patentinhaber: **HOECHST AKTIENGESELLSCHAFT
Postfach 80 03 20
D-6230 Frankfurt/Main 80 (DE)**

(72) Erfinder: **Faust, Raimund Josef, Dr. Ing, Dipl.-Chem.
Adolf-Todt-Strasse 5
D-6200 Wiesbaden (DE)**
Erfinder: **Lehmann, Peter, Dr. Dipl.-Chem.
An der Ziegelei 12
D-6233 Kelkheim (DE)**

**EP 0 006 125 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

# Photopolymerisierbares Gemisch und lichtempfindliches Schichtübertragungsmaterial

Die Erfindung betrifft ein photopolymerisierbares Gemisch, das polymere Bindemittel, polymerisierbare Verbindungen und Photoinitiatoren enthält.

Derartige Gemische werden in der Reproduktionstechnik zur Herstellung von Druckplatten, Photoresists, d.h. Ätz- und Galvanoreservagen, und — ggf. farbigen — Reliefbildern verwendet.

Eine besondere Gruppe derartiger Gemische, die zur Photoresistherstellung dienen, wird als trockene photopolymerisierbare Schicht auf einem temporären Schichtträger aus einer transparenten flexiblen Kunststoffolie verwendet, wobei die Schicht unter Druck und Erwärmen auf einen bildmäßig zu modifizierenden Träger aus Metall, z.B. eine Kupferplatte, laminiert, dort belichtet und zum Photoresist entwickelt wird. Die Schichten sollen bevorzugt die Eigenschaft haben, sich mit wäßrigen, normalerweise wäßrigalkalischen Entwicklerlösungen entwickeln zu lassen. Derartige Materialien und Verarbeitungsverfahren sind z.B. in der DE—AS 15 22 515 und den DE—OS 20 64 079 und 23 61 041 beschrieben.

Besonders die in den genannten Offenlegungsschriften beschriebenen Schichten zeigen bei wäßrig-alkalischer Entwicklung eine gute Haftung auf dem Träger, insbesondere auf Kupfer, und eine gute Resistenz gegenüber Ätzlösungen und galvanischen Bädern.

Die hierfür erforderlichen, in wäßrig-alkalischen Lösungen löslichen, mindestens aber quellbaren Bindemittel haben häufig den Nachteil, der belichteten Schicht eine gewisse Sprödigkeit zu verleihen. Das gilt insbesondere für solche Bindemittel, die wegen ihres Gehalts an Monomereinheiten, die dem Polymerisat eine höhere Glastemperatur verleihen, zur Vermeidung des Kaltflusses der unbelichteten Schicht besonders bevorzugt werden. Derartige Bindemittel sind z.B. in der US—PS 3 930 865 beschrieben.

Auch Monomere mit mehr als zwei polymerisierbaren Gruppen im Molekül, die wegen der hohen Vernetzungsdichte ihrer Belichtungsprodukte an sich besonders vorteilhaft sind, führen in der Regel zu Belichtungsprodukten, die relativ spröde sind, insbesondere wenn die Belichtung über das optimale Maß hinaus ausgedehnt wird.

Man kann generell sagen, daß photopolymerisierbare Schichten, deren Kaltfluß im unbelichteten Zustand genügend klein ist, und die nach der Belichtung eine gute Haftung am Trägermetall, eine gute Entwicklerresistenz und Beständigkeit gegen Ätzlösungen und galvanische Bäder aufweisen, verhältnismäßig spröde Belichtungsprodukte bilden. Das gilt besonders bei Überbelichtungen, d.h. es verbleibt für die Verarbeitung derartiger Schichten in der Regel nur ein sehr geringer Belichtungsspielraum, wenn man eine optimale Kombination von Eigenschaften erreichen will. Ein weiteres Verspröden kann schließlich auch beim Lagern oder Handhaben der Produkte bei Tageslicht eintreten.

Durch die erhöhte Sprödigkeit der belichteten und auch der unbelichteten Photoresistschicht treten bei der Weiterverarbeitung, z.B. der Herstellung gedruckter Schaltungen, erhebliche Schwierigkeiten auf. Diese Schwierigkeiten bestehen darin, daß beim Beschneiden der mit dem Trockenresist kaschierten Kupferleiterplatten die spröde Resistschicht zur Bildung von Flittern neigt, die eine erhebliche Verschmutzung und Störung bei der Weiterverarbeitung zur Folge haben können. Zum anderen brechen die spröden Resistüberhänge beim Ätzen in den üblichen Sprühätzmaschinen leicht ab, oder es kommt zum Abplatzen feinerer Details der Photomasken in ungünstigen Galvanobädern, insbesondere bei Goldbädern, bei denen die Stromausbeute relativ gering ist (z.B. 45% bis herab zu 25%). Hierbei verursacht der entstehende Wasserstoff leicht ein Abplatzen von spröden Resistmasken.

Die hier beschriebenen Probleme sind zwar für die genannte Kombination von Schichtbestandteilen und Verarbeitungsbedingungen noch nirgends deutlich aufgezeigt worden. Man hat sich aber schon grundsätzlich mit dem Problem der Sprödigkeit von photopolymerisierbaren Schichten beschäftigt und zu seiner Lösung den Zusatz von Weichmachern empfohlen. So werden in der DE—AS 23 27 513, Spalte 14, als Weichmacher für bestimmte Typen photopolymerisierbarer Schichten Dibutylphthalat und andere Ester aromatischer und aliphatischer Dicarbonsäuren, Glykolester, Polyglykole, Alkyl- und Aryl-phosphate, bestimmte Sulfonamide und andere Verbindungen genannt. Diese und andere ähnliche Weichmacher werden auch in der US—PS 3 192 194, Spalte 4, und in der DE—AS 23 37 645, Spalte 12, genannt.

Alle hieraus bekannten Weichmacher haben in alkalisch entwickelbaren photopolymerisierbaren Schichten der oben bezeichneten Art bestimmte Nachteile. Viele sind mit den erforderlichen alkalilöslichen Bindemitteln nicht verträglich und schwitzen bei der Lagerung aus der unbelichteten oder aus der belichteten Schicht aus. Andere haben zwar eine gute Weichmacherwirkung und sind gut verträglich, ergeben aber Schichten mit zu hohem Kaltfluß in unbelichtetem Zustand. Andere weiderum setzen die Entwickler-resistenz der belichteten Schichtteile, deren Beständigkeit gegen galvanische Bäder oder deren Haftung auf dem metallischen Träger zu stark herab.

Aufgabe der Erfindung war es, durch Auffinden neuer Weichmacher für photopolymerisierbare Gemische eine Schichtkombination vorzuschlagen, die die oben aufgezeigten Nachteile nicht aufweist. Insbesondere sollte die unbelichtete Schicht einen geringen Kaltfluß aufweisen und bei der Lagerung unverändert homogen bleiben. Die Schicht sollte nach der Belichtung eine hohe Vernetzungsdichte und damit hohe Entwickler- und Galvano-resistenz sowie eine gute Haftung auf metallischen Trägern, insbesondere auf Kupfer, aufweisen, jedoch auch bei beträcht-licher Uberbelichtung noch flexibel sein.

Die Erfindung geht aus von einem photopolymerizierbaren Gemisch, das ein polymeres, in wäßrig-alkalischen Lösungen lösliches oder mindestens quellbares Bindemittel, eine zur Additionspolymerisation befähigte Verbindung mit mindestens zwei Acryl- oder Methacrylsäureestergruppen im Molekül und einem Siedepunkt oberhalb 100°C, einen Photoinitiator und einen Weichmacher enthält.

Das erfindungsgemäße Gemisch ist dadurch gekennzeichnet, daß der Weichmacher eine Verbindung der Formel I

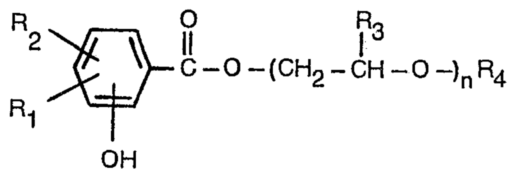

(I)

ist, worin

$R_1$ ein Wasserstoff- oder Halogenatom oder ein Alkylrest mit 1 bis 4 Kohlenstoffatomen,
$R_2$ ein Wasserstoffatom, eine OH-Gruppe oder ein Alkylrest mit 1—4 Kohlenstoffatomen,
$R_3$ ein Wasserstoffatom oder eine Methylgruppe,
$R_4$ einen Alkyl- oder Alkenylrest mit 1 bis 20 C-Atomen und
n Null oder eine Zahl 1 bis 20 bedeutet,

wobei $R_4$ mindestens 4 C-Atome hat, wenn n Null oder 1 ist.

Der erfindungsgemäße Gemisch enthält im allgemeinen 1 bis 30 Gew.-% der neuen Weichmacher, bezogen auf die Menge der nichtflüchtigen Bestandteile. Vorzugsweise werden 10 bis 25 Gew.-% zugesetzt. Bei mehr als 30 Gew.-% Zusatz werden auch noch belichtete Schichtbereiche mit ausgezeichneter Flexibilität und anderen vorteilhaften Eigenschaften erhalten, jedoch zeigt dann die unbelichtete Schicht meist schon einen merklichen Kaltfluß, der bei der Anwendung als Trockenresistfolie stören kann. Wenn es nicht beabsichtigt ist, das Gemisch in Form der trockenen unbelichteten Schicht in aufgerollter Form längere Zeit zu lagern, wenn also das Gemisch in gelöster Form als Flüssigresist gelagert und unmittelbar vor der Anwendung auf einen Träger aufgebracht werden soll, fällt dieser Nachteil nicht ins Gewicht, so daß auch höhere Konzentrationen, etwa bis zu 40 Gew.-% Weichmacher, angewendet werden können.

Wenn die Weichmacher Oxyalkyleneinheiten enthalten, also n ungleich Null ist, sind diese Einheiten bevorzugt Oxyäthyleneinheiten ($R_3 = H$). Die Anzahl n der Oxyalkyleneinheiten ist vorzugsweise 1 bis 6. Eine besonders hohe Galvanoresistenz wird mit Verbindungen mit $n = 3$ und $R_3 = H$ erzeilt.

Der Rest $R_4$ ist von einem ungesättigten oder vorzugsweise gesättigten geradkettigen oder verzweigten aliphatischen Alkohol mit 1 bis 20 C-Atomen abgeleitet. Auch wenn n größer als 1 ist, hat der Rest $R_4$ vorzugsweise 4 bis 20 C-Atome. Umgekehrt werden auch bei $R_4$ mit 4 oder mehr C-Atomen solche Verbindungen bevorzugt, in denen n mindestens 1 ist. Im Falle von $n = 0$ hat der Rest $R_4$ vorzugsweise mindestens 6 C-Atome.

Beispiele für Alkohole $R_4$ OH, die zur Herstellung geeigneter Weichmacher verwendet werden können, sind Methanol, Isopropanol, Isoamylalkohol, n-Hexanol, 2,4-Dimethyl-hexanol, Isooctanol, Decanol, Octadecylalkohol und Geraniol.

Als Hydroxybenzolcarbonsäuren, die zur Herstellung von Verbindungen der Formel I verwendet werden können, sind z.B. Salicylsäure, 4-Hydroxy-3-chlor-benzoesäure, 2,5-Dihydroxy-4-äthylbenzoesäure, 2,4-Dihydroxy-benzosäure, 4-Brom-3-hydroxy-benzoesäure und 2-Hydroxy-4-chlor-6-methyl-benzosäure geeignet. Wenn $R_1$ ein Halogenatom bedeutet, ist es vorzugsweise Chlor oder Brom. Verbindungen mit $R_1$ = Wasserstoff oder Alkyl werden im allgemeinen bevorzugt.

Die neuen Weichmacher weisen eine gute Verträglichkeit mit den übrigen Bestandteilen der Schicht, insbesondere mit den weiter unten beschriebenen bevorzugten Bindemitteln und Monomeren auf. Sie zeigen auch bei längerer Lagerung bei höheren Temperaturen, z.B. bei 50 oder 100°C, keine Neigung zur Auswanderung aus der Schicht. Auch in den gebräuchlichen sauren galvanischen Bädern findet keine Auswanderung statt. Mit den Weichmachern werden photopolymerisierbare Schichten erhalten, die vor und vor allem auch nach der Belichtung ausgezeichnet flexibel sind. Sie ergeben bei Kombination mit geeigneten Bindemitteln und Monomeren Schichten, die nur geringen oder gar keinen Kaltfluß aufweisen. Es zeigte sich ferner, daß bei Verwendung der beschriebenen Weichmacher die Galvanoresistenz der belichteten Schicht, insbesondere gegenüber sauren Goldbädern, in überraschender Weise im Vergleich zu der weichmacherfreien Schicht erhöht wird, obwohl andere, bekannte Weichmacher die Galvano-resistenz häufig verschlechtern. Die erwünschte Kombination von schwer miteinander zu vereinbarenden Eigenschaften bleibt auch bei erheblicher Überbelichtung der Schicht erhalten, so daß dem Verbraucher die kostspielige und mühsame Aufgabe erspart bleibt, für jede Vorlage und Belichtung die optimale Belichtungszeit genau zu ermitteln.

Einzelne Vertreter der Verbindungen der Formel I sind bekannt; so ist der 2-Äthyl-hexylester der 4-Hydroxybenzoesäure als Weichmacher für Polyamide und Polyvinylchlorid beschrieben. Er wird häufig zusammen mit N-Alkyl-phenylsulfonamid oder N-Alkyl-toluolsulfonamid genannt (z.B. in der

DE—B 12 83 796 und der US—A 3 395 060). Ferner sind aus der US—A 2 198 582 Ester der 4-Hydroxybenzoesäure mit Monoalkyläthern von Glykolen oder Oligoglykolen bekannt, die als Weichmacher für Cellulosederivate dienen. Aus diesen Druckschriften geht jedoch nicht hervor, daß die Weichmacher auch für photopolymerisierbare Gemische der oben genannten Art geeignet sind. Das als äquivalent zu dem 4-Hydroxybenzoesäure-2-äthyl-hexylester beschriebene N-Alkyltoluolsulfonamid ist hierfür z.B. völlig ungeeignet und kristallisiert oder schwitzt aus der festen Mischung aus.

Die erfindungsgemäßen Weichmacher sind leicht aus Alkoholen durch azotrope veresterung mit aromatischen Carbonsäuren zugänglich. Als Alkohole finden Anwendung:

a) aliphatische einwertige Alkohole mit 4 bis 20 C-Atomen,

b) Polyglykolmonoalkyläther, die durch Umsetzung von aliphatischen, einwertigen Alkoholen mit 1 bis 20 C-Atomen mit Äthylenoxid oder Propylenoxid erhalten werden.

Die Herstellung von Polyglykolmonoalkyläthern aus Alkoholen und Alkylenoxiden ist bekannt. Solche Verbindungen sind im Handel erhältlich.

Die erfindungsgemäßen photopolymerisierbaren Gemische enthalten ferner polymere, vorzugsweise thermoplastische, in wäßrig-alkalischen Lösungen lösliche oder mindestens quellbare Bindemittel. Derartige Polymere enthalten Gruppen, die im alkalischen Medium Salze bilden, z.B. COOH, $PO_3H_2$, $SO_3NH_2$, $SO_2NHCO$ oder OH-Gruppen, Bevorzugt werden Polymere mit Carboxylgruppen. Geeignete Bindemittel sind Maleinatharze, Polymerisate aus N-(p-Toluolsulfonyl)-carbaminsäure-(β-methacryloyloxy)-äthylester und Mischpolymerisate derartiger Monomerer, Styrol-Maleinsäureanhydrid-Mischpolymerisate und insbesondere Mischpolymerisate von Acryl- und Methacrylsäure. Die letzteren können als Comonomere Alkylacrylate und -methacrylate, wovon mindestens ein Teil Alkylgruppen mit 4 bis 15 C-Atomen hat, und zusätzlich zu diesen Styrol, ein substituiertes Styrol, Acrylnitril, Benzylacrylat oder ein ähnliches Monomeres enthalten, das ein Homopolymerisat mit einer Glastemperatur Tg von mindestens 80°C bildet. Derartige bevorzugte Bindemittel sind in den US—PS 3 804 631 und 3 930 865 beschrieben. Das Bindemittel soll ein mittleres Molekulargewicht von mindestens 10000, vorzugsweise von etwa 20000 bis 200000 haben. Die Säurezahl beträgt im allgemeinen 50 bis 250, vorzugsweise 100 bis 200. Besonders bevorzugt werden Terpolymerisate aus Methacrylsäure, einem Alkylmethylacrylat mit 4 bis 12 C-Atomen im Alkylrest und Styrol oder einem substituierten Styrol. Die Menge der Bindemittel beträgt im allgemeinen 20—80, bevorzugt 35—65 Gew.-% der nichtflüchtigen Bestandteile des Gemischs.

Die erfindungsgemäßen Gemische enthalten ferner polymerisierbare Verbindungen mit mindestens zwei Acryl- oder Methacrylsäureestergruppen im Molekül. Derartige Verbindungen sind in großer Zahl bekannt und für die Herstellung photopolymerisierbarer Gemische gebraüchlich. Beispiele sind Äthylenglykoldiacrylat, Di-, Tri- und Polyäthylenglykoldiacrylat, Hexandiol-(1,6)-diacrylat, Trimethylolpropantriacrylat, Trimethyloläthandiacrylat, Pentaerythrittriacrylat, Neopentylglykoldiacrylat, Diglycerindiacrylat sowie die entsprechenden Methacrylate. In Kombination mit den Estern können auch Amide der Acryl- und Methacrylsäure verwendet werden, z.B. Methylenbis-acrylamid, Hexamethylenbis-acrylamid oder Xylylen-bis-methacrylamid. Bevorzugt werden Acryl- und Methacrylsäureester, die im Molekül mindestens zwei Urethangruppen enthalten, da diese Monomeren Belichtungsprodukte mit guter Flexibilität und Haftung auf Metallen ergeben. Diese Verbindungen können auch Biuret- und ggf. Carbonsäureamidgruppen enthalten. Derartige Verbindungen sind in den DE—OS 20 64 079 und 23 61 041 sowie der US—PS 3 850 770 beschrieben. Beispiele sind Reaktionsprodukte von 2 Molen Hydroxyalkylacrylat oder -methacrylat mit 1 Mol Diisocyanat, z.B. Hexamethylendiisocyanat, 2,2,4-Trimethyl-hexamethylendiisocyanat, Isophorondiisocyanat, Dicylohexylmethandiisocyanat und Tolylendiisocyanat. Aliphatische und cycloaliphatische Diisocyanate mit 2 bis 12 C-Atomen werden generell bevorzugt, von diesen wiederum solche mit mindestens einer seitenständigen Methylgruppe. Mit Vorteil werden ferner Monomere verwendet, die noch mindestens eine Oxyalkyleneinheit, besonders Oxyäthyleneinheiten, im Molekül enthalten. Beispiele sind die Reaktionsprodukte von Hydroxygruppen enthaltenden Acrylaten und Methacrylaten mit Diisocyanaten, die durch partielles Umsetzen einfacher Diisocyanate, wie sie oben genannt wurden, mit Diolen, z.B. Hexandiol, Diäthylenglykol, Triäthylenglykol, Pentaäthylenglykol, Tripropylenglykol und dgl. erhalten worden sind. Diese Verbindungen mit endständigen Isocyanatogruppen können eine oder mehrere Diol- bzw. Polyäthergruppen enthalten.

Besonders bevorzugt werden polymerizierbare Verbindungen, die durch Umsetzen der genannten bevorzugten Diisocyanate mit Di-, Tri- oder Tetraäthylenglykol im Molverhältnis 2:1 bis 1,1:1 und Umsetzen des Reaktionsprodukts mit 1 Mol 2-Hydroxyäthylmethacrylat je 1 Äquivalent Isocyanatogruppen erhalten werden.

Bei der bevorzugten Anwendung der Gemische zur Herstellung von Trockenresistfolien werden generell die Methacrylate bevorzugt. Besonders bevorzugt werden polymerisierbare Verbindungen mit zwei endständigen polymerisierbaren Doppelbindungen. Die Monomeren werden im allgemeinen in einer Menge von 10 bis 70 Gew.-%, vorzugsweise 20 bis 50 Gew.-%, bezogen auf die nichtflüchtigen Bestandteile der Gemisches, eingesetzt.

Als Photoinitiatoren können eine Vielzahl von Substanzen Verwendung finden. Beispiele sind Benzoin, Benzoinäther, Mehrkernchinone, z.B. 2-Äthyl-anthrachinon, Acridinderivate, z.B. 9-Phenyl-acridin, 9-p-Methoxyphenyl-acridin, 9-Acetylamino-acridin, Benz(a)acridin, Phenazinderivate, z.B. 9,10-Dimethyl-benz(a)phenazin, 9-Methyl-benz(a)phenazin, 10-Methoxy-benz(a)phenazin, Chinoxalinderivate, z.B. 6,4',4''-Trimethoxy-2,3-diphenyl-chinoxalin, 4',4''-Dimethoxy-2,3-diphenyl-5-aza-chinoxalin, Chinazolinderivate und dergl. mehr. Ihre Menge beträgt im allgemeinen 0,1 bis 10 Gew.-% der nichtflüchtigen Bestandteile des Gemisches.

Das erfindungsgemäße Gemisch kann außer Monomeren, Weichmachern, Photoinitiatoren und Bindemitteln noch eine Reihe weiterer üblicher Zusätze enthalten, z.B. Inhibitoren zur Verhinderung der thermischen Polymerisation der Monomeren, Haftvermittler, Wasserstoffdonatoren, sensitometrische Regler, Farbstoffe, Farbpigmente, ungefärbte Pigmente, Farbbildner und Indikatoren.

Diese Bestandteile sind zweckmäßig so auszuwählen, daß sie in dem für den Initiierungsvorgang wichtigen aktinischen Wellenlängenbereich möglichst nicht zu stark absorbieren.

Das erfindungsgemäße photopolymerisierbare Gemisch kann in bekannter Weise als Lösung oder Dispersion in den Handel gebracht werden, die vom Verbraucher insbesondere zur Herstellung von Ätzschutzschichten verwendet wird. Ein bevorzugtes Anwendungsgebiet für die erfindungsgemäßen Gemische sind Trockenresistfolien, die aus einer auf einem temporären Träger, z.B. einer transparenten Kunststoffolie, befindlichen fertigen Photoresistschicht bestehen und die vom Verbraucher auf die bildmäßig zu ätzende oder zu galvanisierende Unterlage kaschiert werden und dort belichtet und entwickelt werden, wobei vor dem Entwickeln der temporäre Träger entfernt wird.

Das erfindungsgemäße Gemisch eignet sich besonders gut für diese Anwendungsform. Es kann aber auch in Form eines vorsensibilisierten Kopiermaterials auf einem geeigneten Träger, z.B. auf Aluminium oder Zink, für die photomechanische Herstellung von Offset- oder Hochdruckformen fabrikmäßig hergestellt werden. Es ist ferner zur Herstellung von Reliefbildern, Siebdruckschablonen, Farbprüffolien und dergl. geeignet. Seine Vorteile kommen in allen den Fällen zur Geltung, wo es auf gute und darüber) kann man auch durch Extrudieren oder Verpressen als selbsttragende Folie herstellen, sowie hohe Resistenz der belichteten Schicht gegen aggressive Chemikalien ankommt.

Die Herstellung der lichtempfindlichen Materialien unter Verwendung des erfindungsgemäßen Gemisches erfolgt in bekannter Weise. So kann man die Mischung in einem Lösungsmittel aufnehmen und die Lösung bzw. Dispersion durch Gießen, Sprühen, Tauchen, Antragen mit Walzen usw. auf den vorgesehenen Träger als Film aufbringen und anschließend trocknen. Dicke Schichten (z.B. von 250 μm und darüber) kann man auch durch Extrudieren oder Verpressen als selbstragende Folie herstellen, welche dann auf den Träger laminiert wird.

Als Träger für die zu Kopierschichten verarbeiteten Gemische kommen Metalle, z.B. Aluminium, Zink, Kupfer, Stahl, Chrom, Messing und andere Metallegierungen; Siebdruckschablonenträger, z.B. aus Nickel oder Perlongaze; und Kunststoffolien in Frage, wobei die Kunststoffolien, z.B. Polyesterfolien, speziell oberflächenbehandelt sein können.

Die Kopierschichten werden in bekannter Weise belichtet und entwickelt. Als Entwickler sind wäßrige, vorzugsweise wäßrigalkalische Lösungen, z.B. von Alkaliphosphaten oder Alkalisilikaten, geeignet, denen gegebenenfalls kleine Mengen, z.B. bis zu 10, vorzugsweise weniger als 5, Gew.-% an wassermischbaren organischen Lösungsmitteln oder auch Netzmittel zugesetzt werden können. Die Entwicklung kann von Hand oder in handelsüblichen Sprüh- oder Bürstentwicklungsgeräten erfolgen.

Die erfindungsgemäßen Gemische lassen sich, wie oben erwähnt, für die verschiedensten Anwendungsgebiete einsetzen. Mit besonderem Vorteil werden sie zur Herstellung von Photoresist- bzw. Ätzschutzschichten auf metallischen Trägern verwendet. Vor allem sind sie zur Anwendung auf Trägern aus Kupfer geeignet. Die ausgezeichnete Haftung und Flexibilität der belichteten Schichtteile bewährt sich bei diesen bevorzugten Anwendungsformen nicht nur während der Entwicklung, sondern auch während einer nachfolgenden Ätzung des Trägers, bei der die Schichten eine gute Flexibilität und Ätzresistenz zeigen.

Die Gemische lassen sich besonders gut in der form sogenannter Trockenresistmaterialien, wie sie oben erwähnt wurden, einsetzen und handhaben, da sie sich auch trocken zu gut haftenden Schichten auf Metallträger übertragen lassen. In diesem Fall sind als temporäre Trägerfolien besonders Polyesterfolien geeignet.

Die folgenden Beispiele erläutern einzelne Ausführungsformen des erfindungsgemäßen Gemischs. Wenn nichts anderes angegeben ist, sind Prozentzahlen und Mengenverhältnisse in Gewichtseinheiten zu verstehen.

## Beispiel 1a

Eine Lösung aus:

6,5 g eines Terpolymerisats aus n-Hexylmethacrylat, Methacrylsäure und Styrol (60:30:10 Gew.-Teile) mit einem mittleren Molgewicht von ca. 35000.

2,8 g eines polymerisierbaren Diurethans, das durch Umsetzung von 1 Mol 2,2,4-Trimethylhexamethylendiisocyanat mit 2 Molen Hydroxyäthylmethacrylat erhalten wurde.

2,8 g eines polymerisierbaren Polyurethans, das durch Umsetzung von 11 Molen 2,2,4-Trimethylhexamethylendiisocyanat mit 10 Molen wasserfreiem Triäthylenglykol und weitere Umsetzung des Reaktionsprodukts mit 2 Molen Hydroxyäthyl-methacrylat hergestellt wurde,

0,2 g 9-Phenyl-acridin,

0,1 g 3-Mercapto-propionsäure-2,4-dichlor-anilid,

0,035 g eines blauen Azofarbstoffs, erhalten durch Kuppeln von 2,4-Dinitro-6-chlorbenzoldiazoniumsalz mit 2-Methoxy-5-acetylamino-N-cyanoäthyl-N-hydroxyäthylanilin und

2,8 g des Esters von 2,6-Dihydroxy-benzoesäure mit Diäthylenglykol-mono-2-äthylhexyläthyl in

35 g Methyläthylketon und

2 g Äthanol

wird auf eine biaxial verstreckte und thermofixierte Polyäthylenterephthalatfolie der Stärke 25 $\mu$m so aufgeschleudert, daß nach dem Trocknen bei 100°C ein Schichtgewicht von 28 g/m² erhalten wird.

Man erhält eine Trockenresistfolie, die mit einer handelsüblichen Laminiervorrichtung bei 120°C auf eine mit 35 $\mu$m starker Kupferfolie kaschierte Phenoplast-Schichtstoffplatte laminiert und 8 Sekunden mit einem handelsüblichen Belichtungsgerät belichtet wird. Als Vorlage dient eine Strichvorlage mit Linienbreiten und Abständen bis herab zu 80 $\mu$m.

Nach der Belichtung wird die Polyesterfolie abgezogen und die Schicht in einer 0,8%igen $Na_2CO_3$-Lösung in einem Sprühentwicklungsgerät 50 Sekunden lang entwickelt.

Die Platte wird dann 30 Sekunden mit Leitungswasser gespült, 1 Minute in einer 25%igen Ammoniumperoxydisulfat-Lösung angeätzt und sodann nacheinander in den folgenden Elektrolytbädern galvanisiert:

1.) 40 Minuten in einem Kupferelektrolytbad der Firma Blasberg, Solingen, Typ "Feinkornkupferplastic-Bad"
Stromdichte: 2 A/dm²
Metallaufbau: ca. 20 $\mu$m

2.) 10 Minuten in einem Nickelbad Typ "Norma" der Firma Blasberg, Solingen
Stromdichte: 4 A/dm²
Metallaufbau: 6 $\mu$m und

3.) 15 Minuten in einem Goldbad Typ "Autronex N" der Firma Blasberg, Solingen
Stromdichte: 0,6 A/dm²
Metallaufbau: 2,5 $\mu$m

Die Platte zeigt keinerlei Unterwanderungen oder Beschädigungen.

Die Platte kann sodann in 5%iger KOH-Lösung bei 50°C entschichtet und das freigelegte Kupfer in den üblichen Ätzmedien weggeätzt werden.

Die oben beschriebene Trockenresistfolie ist auch bei 10-facher Überbelichtung, also auch noch nach 80 Sekunden Belichtungszeit mit dem oben beschriebenen Belichtungsgerät völlig flexibel. Dies kann man zeigen, wenn man einen etwa 2 cm breiten und 20 cm langen Streifen aus Trägerfolie und Schicht im belichteten Zustand mit der Hand dehnt. Hierbei läßt sich der 10-fach überbelichtete Trockenresiststreifen ohne Platzen oder Reißen der Schicht auf mindestens das Doppelte der Länge bei Zimmertemperatur verstrecken.

Diese Flexibilität ist in vielen Verarbeitungsschritten, wie Beschneiden nach dem Laminieren, Ätzen und Galvanisieren in Goldbädern u.a. von ausschlaggebendem Vorteil. Die oben beschriebene Trockenresistfolie hat ferner einen sehr geringen Kaltfluß im unbelichteten Zustand, der das Lagern von Rollen auch über lange Zeit ohne Ausquellen der Resistschicht an den Rändern ermöglicht.

### Beispiele 1b bis 1g

Statt des in Beispiel 1a beschriebenen Weichmachers können auch folgende Weichmacher benutzt werden:

1b) 2,8 g des Esters aus 2,4-Dihydroxy-benzoesäure und Diäthylenglykol-mono-2-äthylhexyläther

| | |
|---|---|
| Schichtgewicht: | 29 g/m² |
| Belichtungszeit: | 6 Sekunden |
| Verarbeitung: | wie oben mit gleich guten Galvanoresistenzen |
| Flexibilität: | auch bei 10-facher Belichtungszeit noch dehnbar ohne Reißen oder Verspröden der Schicht |

1c) 2,8 g des Esters aus 2,6-Dihydroxy-benzoesäure und Triäthylenglykol-mono-2-äthylhexyläther.

Ergebnis: wie oben,
bei einem Schichtgewicht von 27 g/m²

1d) 2,8 g des Esters aus 2,6-Dihydroxy-benzoesäure und Tripropylenglykol-mono-2-äthylhexyläther.

Ergebnis: wie oben, Schichtgewicht: 27 g/m²

1e) 2,8 g des Esters aus 2,6-Dihydroxy-benzoesäure und Hexaäthylenglykol-mono-2-äthylhexyläther

Ergebnis: wie oben,
Schichtgewicht: 27 $g/m^2$

1f) 2,8 g des Esters aus 4-Hydroxy-toluol-2-carbonsäure und Diäthylenglykol-monohexyläther.
Ergebnis: wie oben,
Schichtgewicht: 32 $g/m^2$

1g) 2,8 g 4-Hydroxy-toluol-2-carbonsäure-n-hexylester
Ergebnis: wie oben,
Schichtgewicht: 32 $g/m^2$

Vergleichsbeispiel 1h

Stellt man eine Lösung aus
6,5 g des Terpolymerisats von Beispiel 1a
2,8 g des Diurethans von Beispiel 1a
2,8 g des Polyurethans von Beispiel 1a
0,2 g 9-Phenyl-acridin
0,1 g 3-Mercapto-propionsäure-2,4-dichlor-anilid und
0,035 g des in Beispiel 1a angegebenen Farbstoffs
in
35 g Methyläthylketon und
2 g Äthanol
her (also ohne Zusatz von Weichmacher), dann erhält man eine Trockenresistfolie, die auch bei einfacher Belichtungszeit schon relativ spröde ist und nach erhöhen der Belichtung um 50% beim Dehnen mit den Händen reißt und splittert.

Vergleichsbeispiel 1i

Eine Lösung von
6,5 g des Terpolymerisats aus Beispiel 1a
5,6 g des Diurethans aus Beispiel 1a
2,8 g des Polyurethans aus Beispiel 1a
0,2 g 9-Phenyl-acridin
0,1 g 3-Mercapto-propionsäure-2,4-dichlor-anilid und
0,035 g des in Beispiel 1a genannten Farbstoffs in
35 g Methyläthylketon und
2 g Äthanol
wird wie in Beispiel 1a auf eine Trägerfolie aufgebracht, so daß eine Schicht von 30 $g/m^2$ erhalten wird. Auch diese Folie wird bereits bei 10 Sekunden Belichtungszeit spröde und splittert.

Beispiel 2a

Eine Lösung von
6,5 g des in Beispiel 1a beschriebenen Terpolymerisats
2,8 g des in Beispiel 1a genannten Diurethans
2,8 g des in Beispiel 1a genannten Polyurethans
0,2 g 9-Phenyl-acridin
0,1 g 3-Mercapto-propionsäure-2,4-dichlor-anilid
0,035 g des in Beispiel 1a genannten Farbstoffs und
2,8 g eines Weichmachers, der aus 4-Hydroxy-benzoesäure durch azeotrope Veresterung mit Triäthylenglykol-mono-tridecyläther (technisches Produkt) erhalten wird, in
35 g Methyläthylketon und
2 g Äthanol
wird wie in Beispiel 1a beschrieben zu einer Trockenresistfolie mit einem Schichtgewicht von 28 $g/m^2$ verarbeitet.

Die Belichtung mit dem in Beispiel 1a verwendeten Belichtungsgerät liefert bereits nach 8 Sekunden eine optimal belichtete Leiterplatte, die nach dem Entwickeln in 0,8%iger $Na_2CO_3$-Lösung eine originalgetreue Wiedergabe der Linienvorlage liefert.

Auch bei 10-facher Überbelichtung ist der Resist noch dehnbar und knickt und reißt nicht.

Beispiel 2b

Statt des in Beispiel 2a angegebenen Weichmachers werden 2,8 g des Salicylsäureesters von Triäthylenglykolmonoäthyläther verwendet.

Schichtgewicht der Trockenresistfolie: 29,4 $g/m^2$
Belichtungszeit: 10 Sekunden
Entwicklung: 70 Sekunden in 0,8%iger $Na_2CO_3$-Lösung
Galvanoresistenz: sehr gut, auch im Goldbad (s. Beispiel 1a)
Flexibilität: auch bei 80 Sekunden Belichtungszeit noch voll flexibel ohne Reißen oder Splittern beim Dehnen der Resistschicht.

Beispiele 2c—2g

Gleich gute Ergebnisse werden erhalten, wenn man als Weichmacher in der Rezeptur 2a jeweils 2,8 g der folgenden Verbindungen verwendet:

2c) Ester aus 4-Hydroxy-benzoesäure und Triäthylenglykolmonobutyläther

2d) Ester aus 4-Hydroxy-benzoesäure und 2-Äthyl-hexanol

2e) Ester aus 4-Hydroxy-benzoesäure und Isotridecylalkohol

2f) Ester aus 3-Hydroxy-benzoesäure und 2-Äthyl-hexanol

2g) Ester aus 4-Hydroxy-benzoesäure und Hexaäthylenglykolmono-2-äthylhexyl-äther.

In jedem Falle werden bei Schichtgewichten um 30 g/m² und stark überbelichteten Trockenresistfolien (z.B. mit dem in Beispiel 1a verwendeten Belichtungsgerät auch noch bei 160 Sekunden Belichtungszeit) noch flexible Schichten erhalten. Die Galvanoresistenzen sind ausgezeichnet.

Beispiel 3a

Eine Lösung von

6,5 g des in Beispiel 1a angegebenen Terpolymerisats

5,0 g eines polymerisierbaren Polyurethans, das durch Umsetzen von 2 Molen 2,2,4-Trimethylhexamethylendiisocyanat und 1 Mol Triäthylenglykol und weiteres Umsetzen des Reaktionsprodukts mit 2 Molen Hydroxyäthylmethacrylat hergestellt wurde

2,8 g 4-Hydroxy-benzoesäure-2-äthylhexylester

0,2 g 9-Phenyl-acridin und

0,025 g des Farbstoffs "Disperse Red" (C. J. 179) in

25 g Methyläthylketon und

2 g Äthanol

wird wie in Beispiel 1a beschrieben auf eine Polyesterfolie aufgeschleudert und getrocknet, so daß ein Schichtgewicht von 52 g/m² erhalten wird. Es wird durch eine Filmvorlage, die Liniengruppen verschiedener Linienbreite aufweist, mit dem in Beispiel 1a angegebenen Belichtungsgerät 20 Sekunden belichtet.

Nach 120 Sekunden Entwicklung im Sprühentwickler mit 0,8%iger Sodalösung werden noch Linien der Breite 50 $\mu$m aufgelöst. Die Prüfung der Galvanoresistenz in den in Beispiel 1a beschriebenen Galvanobädern einschließlich des Goldbades liefert gute Ergebnisse, ohne daß im kritischen Goldbad das übliche Abplatzen von Resistlinien oder eine Unterwanderung beobachtet wird.

Die Flexibilität ist auch bei 160 Sekunden Belichtungszeit noch sehr gut.

Die Entwicklerresistenz beträgt auch in den 50 $\mu$m breiten Linien noch mindestens 6 Minuten.

Beispiel 3b (Vergleichsbeispiel)

Läßt man in Beispiel 3a den Weichmacher fort, dann erhält man schon bei einfacher Belichtung verhältnismaßig spröde Schichten, die beim Verbiegen brechen und sich nicht dehnen lassen. Die Galvanoresistenz in dem in Beispiel 1a beschriebenen Goldbad ist nicht ausreichend.

Beispiel 3c (Vergleichsbeispiel)

Ersetzt man in Beispiel 3a den Weichmacher durch die gleiche Menge (2,8 g) des dort verwendeten Monomeren, d.h. verwendet man insgesamt 7,8 g des Monomeren ohne Zusatz eines Weichmachers, dann erhält man die gleichen schlechten Ergebnisse wie in Beispiel 3b.

Beispiel 4a

Eine Lösung von

6,5 g des in Beispiel 1a angegebenen Terpolymerisats,

5,0 g des in Beispiel 3a angegebenen polymerisierbaren Polyurethans,

2,8 g des 4-Hydroxy-benzoesäureesters von Triäthylenglykol-mono-2-äthylhexyläther,

0,2 g 9-Phenyl-acridin und

0,025 g des Farbstoffs "Disperse Red" (C. J. 179) in

25 g Methyläthylketon und

2 g Äthanol

wird wie in Beispiel 1a beschrieben auf eine Polyesterfolie aufgeschleudert und getrocknet, so daß ein Schichtgewicht von 51 g/m² erhalten wird. Bei Verarbeitung in der in Beispiel 3a angegebenen Weise werden im wesentlichen gleiche Ergebnisse wie dort erhalten.

Beispiel 4b (Vergleichsbeispiel)

Beispiel 4a wird wiederholt mit der Ausnahme, daß statt des dort angegebenen Weichmachers die gleiche Menge Diisodecyladipat verwendet wird. Die Verbindung ist als Weichmacher für Polymere handelsüblich. Bereits bei 15 Sekunden Belichtung wird die Schicht spröde. Außerdem ist die Haftung auf Kupfer schlecht.

Beispiel 4c (Vergleichsbeispiel)

Beispiel 4a wird wiederholt mit der Ausnahme, daß statt des dort angegebenen Weichmachers die gleiche Menge

c 1) Polyester aus Adipinsäure und 1,2-Propandiol oder

c 2) Polyester aus Adipinsäure und Butandiol

verwendet wird. Beide Verbindungen sind handelsübliche Weichmacher. Bereits bei einfacher Belichtungszeit (20 Sekunden) werden spröde Resistschichten erhalten. Diese Schichten haften außerdem schlecht auf Kupfer.

Beispiel 5a

Eine Lösung von

6,5 g des in Beispiel 1a angegebenen Terpolymerisats,

5,0 g des in Beispiel 1a angegebenen polymerisierbaren Diurethans,

2,8 g 4-Hydroxy-benzoesäure-nerolidylester,

0,2 g 9-Phenyl-acridin und

0,025 g des Farbstoffs "Disperse Red" (C. J. 179) in

25 g Methyläthylketon und

2 g Äthanol

wird wie in Beispiel 1a beschrieben auf eine Polyesterfolie aufgeschleudert und getrocknet, so daß ein Schichtgewicht von 50 g/m² erhalten wird. Die Verarbeitung erfolgt wie in Beispiel 3a. Auch nach Überschreiten der erforderlichen Belichtungszeit um 200% ist die belichtete Resistschicht noch genügend flexibel.

Beispiel 5b (Vergleichsbeispiel)

Beispiel 5a wird wiederholt mit der Ausnahme, daß der dort angegebene Weichmacher durch die gleiche Menge N-Athyl-p-toluolsulfonamid (handelsüblicher Weichmacher) ersetzt wird. Unmittelbar nach der Herstellung der Resistschicht behält diese bei Normal- und Überbelichtung eine gute Flexibilität. Bereits nach 2 bis 3 Tagen Lagerung der unbelichteten Schicht werden nach der Belichtung Versprödungserscheinungen festgestellt. Nach 4 Wochen Lagerung ist der Weichmacher zu einem erheblichen Teil ausgewandert, und die Resistfolie ist nicht mehr verwendbar.

Beispiel 5c (Vergleichsbeispiel)

Beispiel 5a wird wiederholt mit der Ausnahme, daß der dort angegebene Weichmacher durch die gleiche Menge

c 1) Diisooctylphthalat oder

c 2) Trikresylphosphat

ersetzt wird. Man erhält bereits bei einfacher Belichtungszeit (20 Sekunden) spröde Schichten.

Bei Verwendung der gleichen Menge

c 3) Polyäthylenglykol mit dem mittleren Molekulargewicht 1000

als Weichmacher wird eine Schicht erhalten, die nicht mehr ausreichend auf Kupfer haftet.

**Patentansprüche**

1. Photopolymerisierbares Gemisch, enthaltend ein polymeres, in wäßrig-alkalischen Lösungen lösliches oder quellbares Bindemittel, eine zur Additionspolymerisation befähigte Verbindung mit mindestens zwei Acryl- oder Methacrylsäureestergruppen und einem Siedepunkt oberhalb 100°C, einen Photoinitiator und einen Weichmacher, dadurch gekennzeichnet, daß der Weichmacher eine Verbindung der Formel I

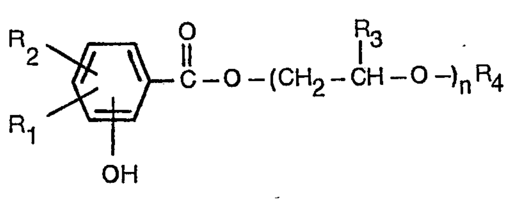

(I)

ist, worin

$R_1$ ein Wasserstoff- oder Halogenatom oder ein Alkylrest mit 1 bis 4 Kohlenstoffatomen,

$R_2$ ein Wasserstoffatom, eine OH-Gruppe oder ein Alkylrest mit 1—4 Kohlenstoffatomen,

$R_3$ ein Wasserstoffatom oder eine Methylgruppe,

$R_4$ einen Alkyl- oder Alkenylrest mit 1 bis 20 C-Atomen und

n Null oder eine Zahl von 1 bis 20 bedeutet,

wobei $R_4$ mindestens 4 C-Atome hat, wenn n Null oder 1 ist.

2. Photopolymerisierbares Gemisch nach Anspruch 1, dadurch gekennzeichnet, daß der Weichmacher eine Verbindung der Formel I ist, worin $R_3$ ein Wasserstoffatom ist.

3. Photopolymerisierbares Gemisch nach Anspruch 1, dadurch gekennzeichnet, daß der Weichmacher eine Verbindung der Formel I ist, worin $R_4$ ein Alkylrest mit 4 bis 20 C-Atomen ist.

4. Photopolymerisierbares Gemisch nach Anspruch 2 und 3, dadurch gekennzeichnet, daß der Weichmacher eine Verbindung der Formel I ist, worin $n = 3$ ist.

5. Photopolymerisierbares Gemisch nach Anspruch 1, dadurch gekennzeichnet, daß es 1 bis 30 Gew.-%, auf die nichtflüchtigen Bestandteile bezogen, an Weichmacher enthält.

6. Photopolymerisierbares Gemisch nach Anspruch 1, dadurch gekennzeichnet, daß es eine polymerisierbare Verbindung enthält, die mindestens zwei Urethangruppen enthält.

7. Photopolymerisierbares Gemisch nach Anspruch 1, dadurch gekennzeichnet, daß die polymerisierbare Verbindung zwei Acryl- oder Methacrylsäureestergruppen im Molekül enthält.

8. Photopolymerisierbares Gemisch nach Anspruch 1, dadurch gekennzeichnet, daß das Bindemittel ein Mischpolymerisat der Acryl- oder Methacrylsäure mit einer Säurezahl von 50 bis 250 ist.

9. Photopolymerisierbares Gemisch nach Anspruch 8, dadurch gekennzeichnet, daß das Mischpolymerisat ein Terpolymerisat aus Methacrylsäure, einem Alkylmethacrylat mit 4 bis 15 C-Atomen in der Alkylgruppe und einem weiteren, damit mischpolymerisierbaren Monomeren ist, dessen zugehöriges Homopolymerisat eine Glastemperatur von mindestens 80°C aufweist.

10. Lichtempfindliches Schichtübertragungsmaterial aus einem temporären flexiblen Schichtträger, einer thermoplastischen photopolymerisierbaren Schicht, die ein polymeres, thermoplastisches, in wäßrig-alkalischen Lösungen lösliches oder quellbares Bindemittel, eine zur Additionspolymerisation befähigte Verbindung mit mindestens zwei Acryl- oder Methacrylsäureestergruppen und einem Siedepunkt oberhalb 100°C, einen Photoinitiator und einen Weichmacher enthält, und gegebenenfalls einem abziehbaren Deckblatt auf der dem Schichtträger abgewandten Seite der Schicht, dadurch gekennzeichnet, daß der Weichmacher eine Verbindung der Formel I

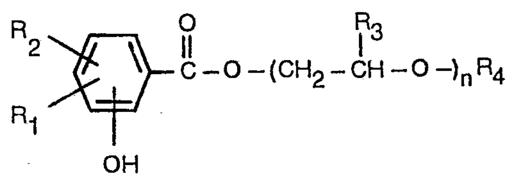

(I)

ist, worin

$R_1$ ein Wasserstoff- oder Halogenatom oder ein Alkylrest mit 1 bis 4 Kohlenstoffatomen,
$R_2$ ein Wasserstoffatom, eine OH-Gruppe oder ein Alkylrest mit 1—4 Kohlenstoffatomen,
$R_3$ ein Wasserstoffatom oder eine Methylgruppe,
$R_4$ einen Alkyl- oder Alkenylrest mit 1 bis 20 C-Atomen und
n Null oder eine Zahl von 1 bis 20 bedeutet,

wobei $R_4$ mindestens 4 C-Atome hat, wenn n Null oder 1 ist.

## Revendications

1. Mélange photopolymérisable, contenant un liant polymère soluble, ou au moins susceptible de gonfler dans des solutions aqueuses alcalines, un composé susceptible d'engager une polymérisation par addition ayant dans sa molécule au moins deux groupes d'ester acrylique ou méthacrylique et un point d'ébullition supérieur à 100°C, un photo-initiateur et un plastifiant, caractérisé en ce que le plastifiant est un composé de formule I:

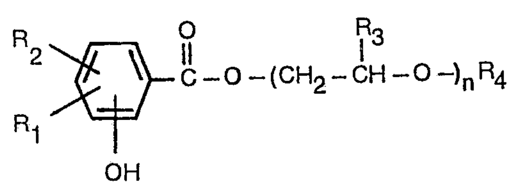

(I)

dans laquelle:

$R_1$ est un atome d'hydrogène ou d'halogène ou un reste alkyle ayant de 1 à 4 atomes de carbone,
$R_2$ est un atome d'hydrogène, un groupe OH ou un reste alkyle ayant de 1 à 4 atomes de carbone,
$R_3$ est un atome d'hydrogène ou un groupe méthyle,
$R_4$ est un reste alkyle ou alcényle ayant de 1 à 20 atomes de C, et
n est zéro ou un nombre compris entre 1 et 20,
$R_4$ ayant au moins 4 atomes de C dans le cas où n est zéro ou 1.

2. Mélange photopolymérisable selon la revendication 1, caractérisé en ce que le plastifiant est un composé de formule I dans laquelle $R_3$ est un atome d'hydrogène.

3. Mélange photopolymérisable selon la revendication 1, caractérisé en ce que le plastifiant est un composé de formule I, dans laquelle $R_4$ est un reste alkyle ayant de 4 à 20 atomes de C.

4. Mélange photopolymérisable selon les revendications 2 et 3, caractérisé en ce que le plastifiant est un composé de formule I dans laquelle $n = 3$.

5. Mélange photopolymérisable selon la revendication 1, caractérisé en ce qu'il contient de 1 à 30% en poids de plastifiant calculés par rapport aux ingrédients non volatils.

6. Mélange photopolymérisable selon la revendication 1, caractérisé en ce qu'il contient un composé polymérisable renfermant au moins deux groupes uréthane.

7. Mélange photopolymérisable selon la revendication 1, caractérisé en ce que le composé polymérisable a dans sa molécule deux groupes d'ester acrylique ou méthacrylique.

8. Mélange photopolymérisable selon la revendication 1, caractérisé en ce que le liant est un copolymère d'acide acrylique ou méthacrylique ayant un indice d'acide compris entre 50 et 250.

9. Mélange photopolymérisable selon la revendication 8, caractérisé en ce que le copolymère est un terpolymère d'acide méthacrylique, d'un méthacrylate d'alkyle ayant de 4 à 15 atomes de C dans le groupe alkyle et encore d'un monomère copolymérisable avec le composé précédent et donnant lui-même un homopolymère ayant une température de transition vitreuse d'au moins 80°C.

10. Matière pour le transfert de couches photosensibles comprenant un support de couche flexible provisoire, une couche photopolymérisable thermoplastique, contenant un liant polymère thermoplastique soluble ou susceptible de gonfler dans des solutions aqueuses alcalines, un composé susceptible d'engager une polymérisation par addition ayant dans sa molécule au moins deux groupes d'ester acrylique ou méthacrylique et un point d'ébullition supérieur à 100°C, un photo-initiateur et un plastifiant, et éventuellement une feuille de recouvrement détachable sur la face de la couche qui n'est pas tournée vers le support de couche, caractérisé en ce que le plastifiant est une composé de formule I:

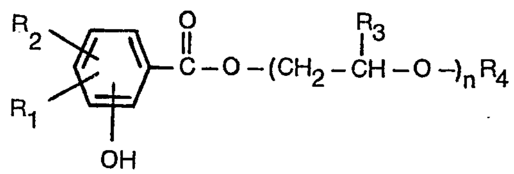

(I)

dans laquelle:

$R_1$ est un atome d'hydrogène ou d'halogène ou un reste alkyle ayant de 1 à 4 atomes de carbone,
$R_2$ est un atome d'hydrogène, un groupe OH ou un reste alkyle ayant de 1 à 4 atomes de carbone,
$R_3$ est un atome d'hydrogène ou un groupe méthyle,
$R_4$ est un reste alkyle ou alcényle ayant de 1 à 20 atomes de C, et
n est zéro ou un nombre compris entre 1 et 20,
$R_4$ ayant au moins 4 atomes de C dans le cas où n est zéro ou 1.

**Claims**

1. A photopolymerizable mixture, comprising a polymeric binder which is soluble or at least swellable in aqueous-alkaline solutions, a compound with at least two acrylic or methacrylic acid ester groups and a boiling point above 100°C which is capable of addition polymerization, a photo-initiator, and a plasticizer, characterized in that the plasticizer is a compound corresponding to Formula I

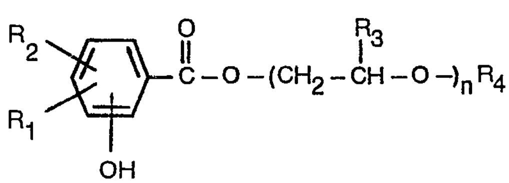

(I)

wherein

$R_1$ is a hydrogen or halogen atom or an alkyl group with 1 to 4 carbon atoms,
$R_2$ is a hydrogen atom, an OH group, or an alkyl group with 1 to 4 carbon atoms,
$R_3$ is a hydrogen atom or a methyl group,
$R_4$ is an alkyl or alkenyl group with 1 to 20 carbon atoms, and
n is zero or a whole number from 1 to 20,

and wherein $R_1$ has at least 4 carbon atoms if n is zero or 1.

2. A photopolymerizable mixture according to claim 1, characterized in that the plasticizer is a compound corresponding to Formula I wherein $R_3$ is a hydrogen atom.

3. A photopolymerizable mixture according to claim 1, characterized in that the plasticizer is a compound corresponding to Formula I wherein $R_4$ is an alkyl group with 4 to 20 carbon atoms.

4. A photopolymerizable mixture according to claims 2 and 3, characterized in that the plasticizer is a compound corresponding to Formula I wherein $n = 3$.

5. A photopolymerizable mixture according to claim 1, characterized in that it contains between 1

and 30 per cent by weight of plasticizer, calculated on the weight of the non-volatile components.

6. A photopolymerizable mixture according to claim 1, characterized in that it contains a polymerizable compound containing at least two urethane groups.

7. A photopolymerizable mixture according to claim 1, characterized in that the polymerizable compound contains two acrylic or methacrylic acid ester groups in the molecule.

8. A photopolymerizable mixture according to claim 1, characterized in that the binder is an acrylic acid or methacrylic acid copolymer with an acid number between 50 and 250.

9. A photopolymerizable mixture according to claim 8, characterized in that the copolymer is a terpolymer of methacrylic acid, an alkylmethacrylate with 4 to 15 carbon atoms in the alkyl group, and a further monomer which can be copolymerized with the first two components and the homopolymer of which has a glass transition temperature of at least 80°C.

10. A light-sensitive layer transfer material, comprising a flexible temporary support and a thermoplastic photopolymerizable layer comprising a polymeric, thermoplastic binder which is soluble or at least swellable in aqueous-alkaline solutions, a compound with at least two acrylic or methacrylic acid ester groups and a boiling point above 100°C which is capable of addition polymerization, a photoinitiator, and a plasticizer, and possibly further comprising a peelable cover film on the surface of the layer remote from the support, characterized in that the plasticizer is a compound corresponding to Formula I

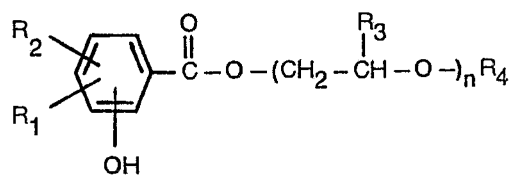

(I)

wherein

$R_1$ is a hydrogen or halogen atom or an alkyl group with 1 to 4 carbon atoms,

$R_2$ is a hydrogen atom, an OH group, or an alkyl group with 1 to 4 carbon atoms,

$R_3$ is a hydrogen atom or a methyl group,

$R_4$ is an alkyl or alkenyl group with 1 to 20 carbon atoms, and

n is zero or a whole number from 1 to 20,

and wherein $R_4$ has at least 4 carbon atoms if n is zero or 1.